# EUROPEAN PATENT APPLICATION

(11) **EP 2 448 126 A1**
(43) Date of publication of application: **02.05.2012**
(21) Application number: 11180522.2
(22) Date of filing: 08.09.2011
(51) Int. Cl.: H03M 13/15

(54) **Decoding apparatus, method, and program**

(30) Priority: 27.10.2010 JP 2010240243
(71) Applicant: Sony Corporation, Tokyo 108-0075 (JP)
(72) Inventor: Yokokawa, Takashi, Minato-ku, Tokyo 108-0075 (JP); Shinya, Osamu, Minato-ku, Tokyo 108-0075 (JP); Nakada, Yutaka, Minato-ku, Tokyo 108-0075 (JP); Ikegaya, Ryoji, Minato-ku, Tokyo 108-0075 (JP)
(74) Representative: Haines, Miles John L.S.

(57) **Abstract**

A decoding apparatus including, a storage section configured to store a reception value, a detection section configured to detect an error in the reception value, an error correction section configured to correct an error detected by the detection section with respect to the reception value, and a control section configured to control reading of the reception value from the storage section, wherein the control section controls first reading such that the reception value is read into the detection section and, after detection of an error by the detection section, second reading such that substantially the same reception value as that in the first reading is read into the error correction section.

## Description

The present invention relates to a decoding apparatus and method and a program and, more particularly, to a decoding apparatus and method and a program that are configured to execute decoding more accurately.

The BCH (Bose-Chaudhuri-Hocquenghem) codes are one of error correction codes and can determine the number of errors that can be corrected by properly selecting parameters. Recently, the BCH codes are employed in the form of linking with the LDPC (Low-Density Parity-Check) codes and employed as the error correction codes of such standards as DVB-T2 (Digital Video Broadcasting-Terrestrial 2), DVB-C2 (Digital Video Broadcasting-Cable 2), and DTMB (Digital Terrestrial Multimedia Broadcast) that are digital broadcast wave standards.

Decoding of BCH codes is executed on a one BCH code word basis and the error correction is executed by:
(1) computing an error position and an error value from reception values; and
(2) removing error values from the data of the obtained error position among the reception values. The following describes an decoding apparatus configured to decode these BCH codes.

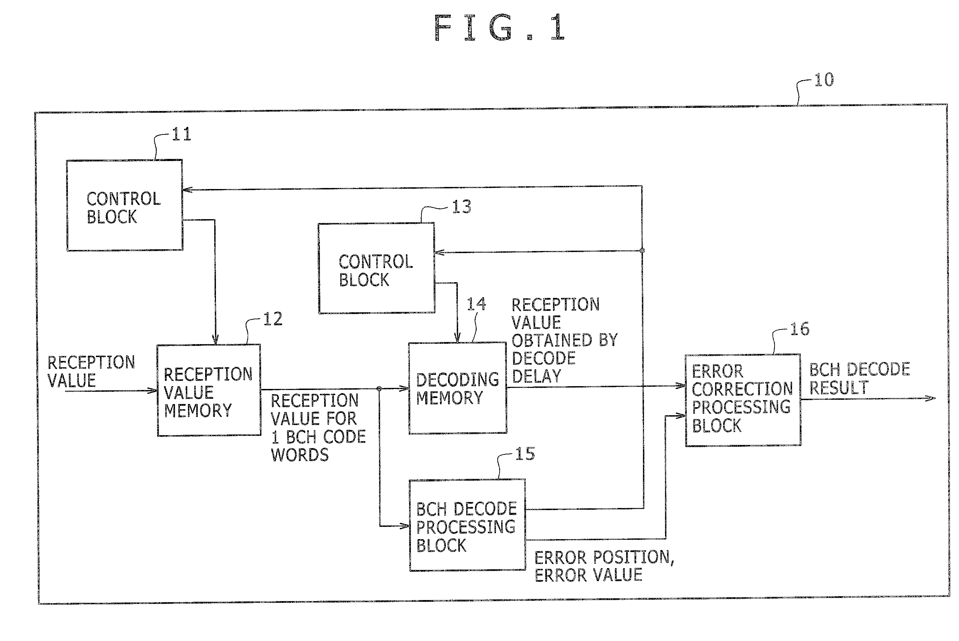

Referring to FIG. 1, there is shown an exemplary configuration of an decoding apparatus configured to decode BCH codes. A decoding apparatus 10 shown in FIG. 1 has a control block 11, a reception values memory 12, a control block 13, a decoding memory 14, a BCH decode processing block 15, and an error correction processing block 16.

The control block 11 controls the reception value memory 12 to store an entered reception value into the reception value memory 12. At the same time, the control block 11 receives a decode end flag from the BCH decode processing block 15 and the control block 11 gives an instruction to the reception value memory 12 to read a next one BCH code word. The reception value read from the reception value memory 12 is entered in the decoding memory 14 and the BCH decode processing block 15.

The control block 13 controls the decode memory 14 to store the reception value (one BCH code word) outputted from the reception value memory 12 into the decode memory 14. At the same time, when the control block 13 receives the decode end flag from the BCH decode processing block 15 after the storing of the reception value for one BCH code word, the control 13 gives an instruction to the decode memory 14 to read the stored reception value.

When the reception value for one BCH code word has been entered, the BCH decode processing block 15 computes an error position and an error value. At the same time, at the end of decoding, the BCH decode processing block generates a decode end flag indicative of the end of decoding and supplies the generated decode end flag to the control block 11 and the control block 13.

The error correction processing block receives the reception value read from the decode memory 14 and the error position and the error value obtained by the BCH decode processing block 15 and removes the error value from the reception value of the error position among the reception values, thereby correcting the error and outputting the BCH decode result to a processing block of the post stage.

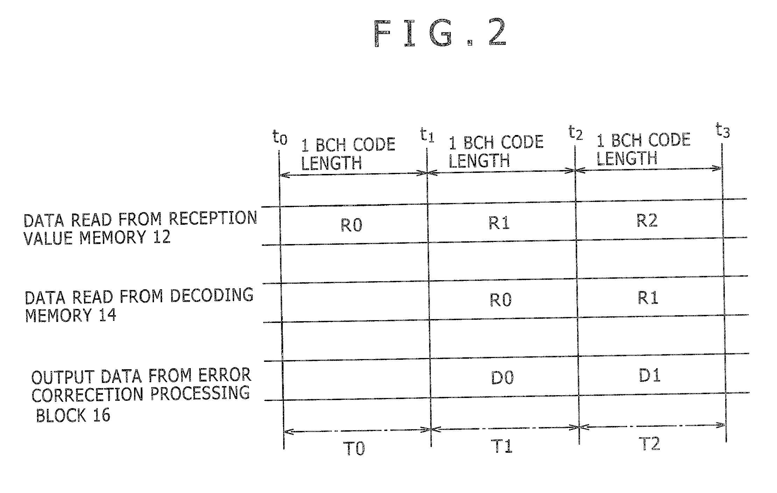

Referring to FIG. 2, there is shown a flow of the decode processing in the decoding apparatus 10 shown in FIG. 1. The following describes the flow of the above-described decode processing with reference to FIG. 2.

Assume that data R0 be data to be read from the reception value memory 12 in duration TO from time t0 to time t1 and this data be a reception value vector for one BCH code length. Then, when data R0 is read from the reception value memory 12 from time t1, this data R0 is supplied to the decode memory 14 to be stored therein and also supplied to the BCH decode processing block 15. The BCH decode processing block starts the decoding of the supplied data R0 from time t0.

At time t1, when the reading of data R0 from the reception value memory 12 has been completed, the storing data R0 by the decode memory 14 has been completed, and the BCH decode processing block 15 has completed the decoding of data R0, then data R0 is outputted from the decode memory 14 to the error correction processing block 16. At the same time, an error position and an error quantity are supplied from the BCH decode block 15 to the error correction processing block 16. In addition, from the reception value 12, data R1 that is next data is outputted to the decode memory 14 and the BCH decode processing block 15. The error correction block 16 executes error correction processing using the error position and the error value on data R0 from time t1, thereby generating data D0 and outputting the generated data to a processing block in the post stage.

At time t2, when the reading of data R1 from the reception value memory has been completed, the storing of data R1 by the decode memory 14 has been completed, and the BCH decode processing block 15 has completed the decoding of data R1, then data R1 is outputted from the decode memory 14 to the error correction processing block 16. At the same time, from the BCH decode processing block 15, an error position and an error quantity are supplied to the error correction processing block 16. In addition, from the reception value memory 12, data R2 that is next data is outputted to the decode memory 14 and the BCH decode processing block 15. From time t2, the error correction processing block 16 executes error correction processing using the error position and the error value on data R1, thereby generating data D1 and outputting the generated data to the processing block in the post stage.

The decode processing for executing error correction in BCH codes is executed by carrying out the above-described processing operations in the component blocks of the decoding apparatus (see Japanese Patent Laid-open No. Hei 06-261024).

Referring to FIG. 1, the decode memory 14 for delaying a reception value by a decode delay of one BCH code word in decoding BCH codes. To be more specific, in the related-art decoding apparatus shown in FIG. 1, two memories, namely, the reception value memory 12 and the decode memory 14 are required. In order to reduce the circuit scale and cut the cost, the reduction of memory in size and number has been desired.

Certain embodiments of the invention provide a decoding apparatus and method and a program that are configured to reduce memory in storage size and quantity without reduced performance of the decoding.

According to one embodiment of the invention, there is provided a decoding apparatus. This decoding apparatus has storage means for storing a reception value; detection means for detecting an error in the reception value; error correction means for correcting an error detected by the detection means with respect to the reception value; and control means for controlling reading of the reception value from the storage means. In this configuration, the control means controls first reading such that the reception value is read into the detection means and, after detection of an error by the detection means, second reading such that substantially the same reception value as that in the first reading is read into the error correction means.

In the above-mentioned decoding apparatus, the detector executes BCH decoding.

In the above-mentioned decoding apparatus, the controller controls reading in unit of a reception value included in one packet.

In the above-mentioned decoding apparatus, the reception value is data after LDPC decoding.

According to another embodiment of the invention, there is provided a decoding method. This decoding method has the steps of: storing a reception value; detecting an error in the reception value; correcting an error detected by the detection means with respect to the reception value; and controlling reading of the reception value from the storage means. In these steps, first reading is controlled in the controlling step such that the reception value is read into the detecting step and, after detection of an error by the detection means, second reading is controlled in the control step such that substantially the same reception value as that in the first reading is read into the error correction step.

According to still another embodiment of the invention, there is provided a program for causing a computer to execute the steps of: storing a reception value; detecting an error in the reception value; correcting an error detected by the detection means with respect to the reception value; and controlling reading of the reception value from the storage means. In these steps, first reading is controlled in the controlling step such that the reception value is read into the detecting step and, after detection of an error by the detection means, second reading is controlled in the control step such that substantially the same reception value as that in the first reading is read into the error correction step.

In the decoding apparatus and method and the program in the above-mentioned embodiments, a reception value is stored, an error in the stored reception value is detected, and the reception value is corrected by the detected error. From the storing means that stores reception value, the same data are read twice to execute error correction processing, thereby reducing memory in storage size and quantity.

As described and according to the above-mentioned embodiments, the memory for use in the processing of decoding can be reduced in storage size and quantity. Even if the memory is reduced, decoding can be executed without involving any deteriorated accuracy of decoding.

### BRIEF DESCRIPTION OF THE DRAWINGS

FIG. 1 is a block diagram illustrating an exemplary configuration of a related-art decoding apparatus for decoding BCH codes;
FIG. 2 is a diagram for describing the processing to be executed by the above-mentioned related-art decoding apparatus;
FIG. 3 is a block diagram for describing a configuration of a receiver apparatus configured to receive digital broadcast waves;
FIG. 4 is a block diagram illustrating an exemplary configuration of a decoding apparatus practiced as one embodiment;
FIG. 5 is a diagram for describing the processing to be executed by the decoding apparatus shown in FIG. 4;
FIG. 6 is a flowchart indicative of the processing to be executed by the decoding apparatus shown in FIG. 4;
FIG 7 is a diagram for describing the processing to be executed by the decoding apparatus shown in FIG. 4; and
FIG. 8 is a block diagram for describing a recording medium.

### DETAILED DESCRIPTION

The invention will be described in further detail by way of embodiments thereof with reference to the accompanying drawings, The decoding apparatus described below is applicable to receiver or reception apparatuses of digital terrestrial broadcasting. Therefore, the following describes the invention embodied in a receiver or reception apparatus.

### [Exemplary configuration of a receiver apparatus]

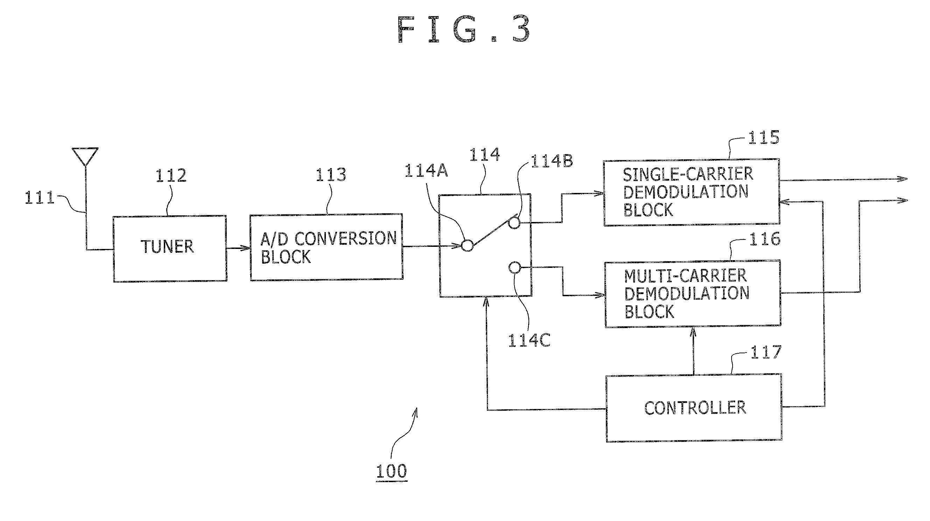

Now, referring to FIG. 3, there is shown an exemplary configuration of a receiver apparatus practiced as one embodiment of the present disclosure.

A receiver apparatus 100 is configured by an antenna 111, a tuner 112, an A/D conversion block 113, a switch block 114, a single-carrier demodulation block 115, a multi-carrier demodulation block 116, and a controller 117. The receiver apparatus 100 is one compliant with the DTMB (Digital Terrestrial Multimedia Broadcast) standard that is one of the terrestrial digital broadcasting standards, for example.

The DTMB standard allows the selection between a single-carrier demodulation scheme and a multi-carrier demodulation scheme for a data demodulation scheme. Receiver apparatuses compliant with the DTMB standard each have a function of demodulating the data transmitted as modulated by use of the single-carrier scheme and a function of demodulating the data transmitted as modulated by user of multi-carrier scheme.

In what follows, the transmission of data by the single-carrier modulation scheme is referred to as single-carrier transmission and the transmission of data by the multi-carrier modulation scheme is referred to as multi-carrier transmission, as appropriate.

The tuner 112 receives an RF (Radio Frequency) signal and outputs an IF (Intermediate Frequency) signal obtained by executing frequency conversion to the A/D conversion block 113.

The A/D conversion block 113 executes A/D conversion on the signal supplied from the 112 and outputs the obtained data as a result of the A/D conversion.

The switch block 114 switches the output destination supplied from the A/D conversion block 113 under the control of the controller 117. In demodulating the data transmitted by single-carrier transmission, the switch block 114 connects a switch 114A to a terminal 114B and outputs the data supplied from the A/D conversion block 113 to the single-carrier demodulation block 115. In demodulating the data transmitted by multi-carrier transmission, the switch block 114 connects the switch 114A to a terminal 114C and outputs the data supplied from the A/D conversion block 113 to the multi-carrier demodulation block 116.

The single-carrier demodulation block 115 demodulates the data supplied from the switch block 114 under the control of the controller 117 and outputs the obtained data as a result of the demodulation.

The multi-carrier demodulation block 116 demodulates the data supplied from the switch block 114 under the control of the controller 117 and outputs the obtained data as a result of the demodulation. If the multi-carrier transmission uses the OFDM (Orthogonal Frequency Division Multiplexing) scheme, then an OFDM signal of baseband obtained by orthogonal demodulation executed by a processing block, not shown, on the output of the A/D conversion block 113 is entered in the multi-carrier demodulation block 116.

The data demodulated by the single-carrier demodulation block 115 or the multi-carrier demodulation block 116 is supplied to a processing block in the post stage to be error-corrected and so on.

The controller 117 executes predetermined programs to control the entire operation of the receiver apparatus 100. For example, in accordance with whether the modulation scheme used in the channel being received is single-carrier transmission or multi-carrier transmission, the controller 117 controls the switch block 114 to switch between data output destinations.

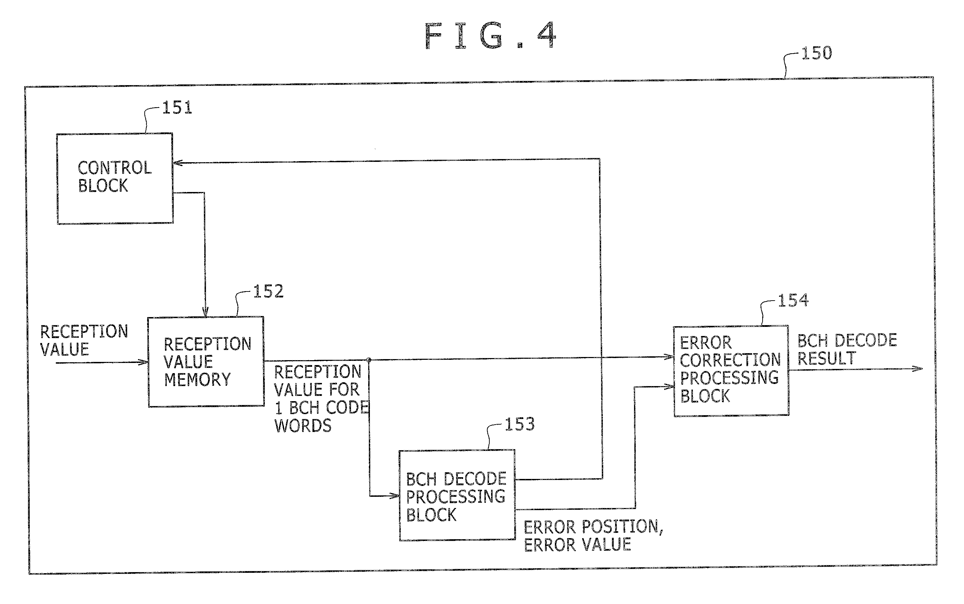

The data demodulated by the single-carrier demodulation block 115 or the multi-carrier demodulation block 116 is entered in a decoding apparatus shown in FIG. 4. A decoding, apparatus 150 shown in FIG. 4 is a decoding apparatus configured to decode BCH codes. The data from the single-carrier demodulation block 115 or the multi-carrier demodulation block 116 is data on which time de-interleave processing for example has been executed and can be BCH-decoded, this data being entered in the decoding apparatus. In the DTMB standard, LDPC decoding is executed after time de-interleave processing and an output from an LDPC decoding block for executing this LDPC decoding entered in the decoding block, so that the data to be entered in the decoding block is a result of the LDPC decoding which can be BCH-decoded.

In the following description, the data to be entered in the decoding apparatus 150 shown in FIG. 4 is written as a reception value. This reception value is obtained data by executing time de-interleave processing and LDPC decode processing on the data demodulated by the single-carrier demodulation block 115 or the multi-carrier demodulation block 116. Alternatively, this reception value is data before being BCH-decoded in the case of BCH decoding in an apparatus based on a standard other than the DTMB standard. Alternatively still, this data may be data transmitted from a predetermined transmission path.

The decoding apparatus 150 shown in FIG. 4 has a control block 151, a reception value memory 152, a BCH decode processing block 153, and an error correction processing block 154.

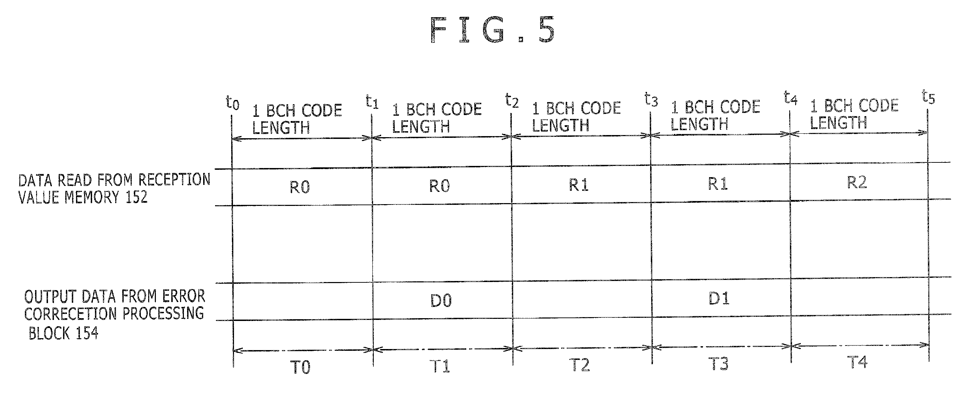

The control block 151 controls the reception value memory 152 to store the reception value entered in the decoding apparatus 150. The reception value stored in the reception value memory 152 is supplied to the BCH decode processing block 153 and the error correction processing block 154 under the control of the control block 151. The reading of the reception value from the reception value memory 152 is executed as follows, details thereof being described later with reference to FIG. 5.

First, the reception value for one BCH code word is read from the reception value memory 152 with a predetermined timing and supplied to the BCH decode processing block 153. This reading for the BCH decode processing block 153 is hereafter appropriately referred to as "the first reading." Then, the BCH decode processing block 153 outputs a decode end flag indicative of the end of the decode processing to the control block 151. When the control block 151 receives this decode end flag, a second reading is executed.

The control block 151 executes control such that the same reception value as the first reading is read from the reception value memory 152 as the second reading. In the second reading, the reception value (for one BCH code word) read from the reception value memory 152 is supplied to the error correction processing block 154. Thus, the control block 151 executes control for reading the same reception value from the reception value memory 152 twice.

When the reception value for one BCH code word read from the reception value memory 152 in the first reading is entered, the BCH decode processing block 153 computes an error position and an error value and holds these values. The BCH decode processing block 153 detects an error of the reception value. Upon computing the error position and the error value, the BCH decode processing block 153 generates a decode end flag and outputs the generated decode end flag to the control block 151.

When the reception value for one BCH code word read from the reception value memory 152 in the second reading and the error position and the error value obtained by the BCH decode processing block 153 are entered, the error correction processing block 154 removes the error value from the reception value of the error position in the reception value to correct the error, thereby decoding the reception value (the code word).

The following describes the processing to be executed in the decoding apparatus 150 shown in FIG. 4 with reference to FIG. 5. Assume that data R0 be data that is read from the reception value memory 152 in duration T0 from time t0 to time t1, this data being a reception value vector for one BCH code length. When data R0 is read from the reception value memory 152 from time t0, this data R0 is supplied to the BCH decode processing block 153. The BCH decode processing block 153 starts the decoding of the supplied data R0 from time t0.

At time t1, the reading of data R0 from the reception value memory 152 is completed and the decoding of data R0 by the BCH decode processing block 153 is completed. Upon completion of the decoding, the BCH decode processing block 153 outputs a decode end flag to the control block 151. At time t1, having received this decode end flag, the control block 151 starts the second reading. Namely, the control block 151 controls the reception value memory 152 from time t1 to give an instruction thereto to output data R0 to the error correction processing block 154 again.

At time t1, an error position and an error quantity are also supplied from the BCH decode processing block 153 to the error correction processing block 154. The error correction processing block 154 executes error correction processing using the error position and the error value on data R0 from time t1, thereby generating data D0, which is outputted to a processing block in the post stage.

At time t2, when data R1 is read from the reception value memory 152, this data R1 is supplied to the BCH decode processing block 153. The BCH decode processing block 153 starts the decoding of the supplied data R1 from time t2. At time t3, the reading of data R1 from the reception value memory 152 is completed and the decoding of data R1 by the BCH decode processing block 153 is completed. Upon completion of the decoding, the BCH decode processing block 153 outputs a decode end flag to the control block 151. At time t3, having received this decode end flag, the control block 151 starts a second reading. Namely, the control block 151 controls the reception value memory 152 from time t3 to give an instruction thereto to output data R1 to the error correction processing block 154 again.

At time t3, an error position and an error quantity are also supplied from the BCH decode processing block 153 to the error correction processing block 154. The error correction processing block 154 executes error correction processing using the error position and the error value on data R1 from time t3, thereby generating data D1, which is outputted to a processing block in the post stage. This processing is repeated in each component block of the decoding apparatus 150.

As described above, the control block 151 controls the reception value memory 152 such that the same reception value is read from the reception value memory 152 twice. The first reading is executed from the reception value memory 152 to the BCH decode processing block 153. The second reading is executed from the reception value memory 152 to the error correction processing block 154. These reading operations allow the removal of the decode memory 14 from the related-art decoding apparatus 10 shown in FIG. 1. In addition, these reading operations allow the removal of the control block 13 for controlling the read/write operations of reception values on the decode memory 14 shown in FIG. 1.

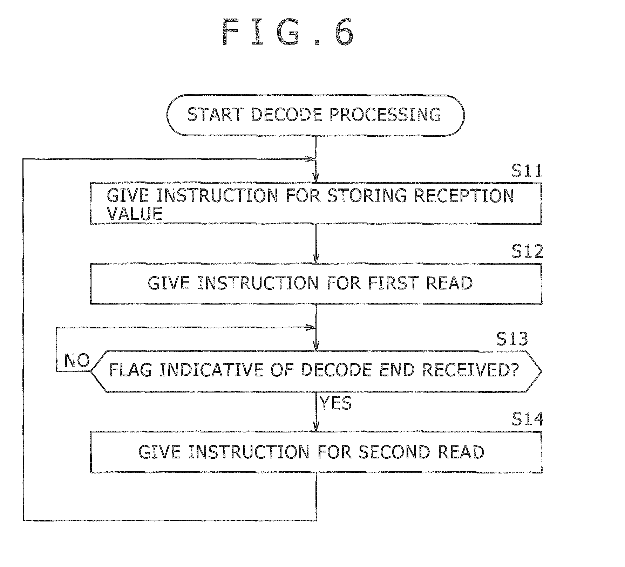

The following describes, with reference to the flowchart shown in FIG. 6, the processing to be executed by the decoding apparatus 150 for executing the decoding described above with reference to FIG. 5. The processing to be described with reference to the flowchart shown in FIG. 6 is mainly executed by the control block 151.

In step S11, the control block 151 controls the reception value memory 152 to store a reception value therein. For example, if a processing block for executing LDPC decoding is arranged in the pre-stage of the decoding apparatus 150, then the LDPC-decoded data is supplied to the reception value memory 152 as a reception value (a BCH code word) to be stored therein.

In step S12, the control block 151 controls the reception value memory 152 to output the reception value for one BCH code word among the stored reception values to the BCH decode processing block 153. Namely, an instruction for the first reading is given.

In step S13, the control block 151 determines whether a signal indicative of the end of decoding has been received from the BCH decode processing block 153. The BCH decode processing block 153 is configured such that, when the decoding has ended and an error position and an error value have been computed, a decode end flag indicative of the end of decoding is outputted to the control block 151. In addition, if an error position and an error value have been computed, the BCH decode processing block 153 outputs these values to the error correction processing block 154.

The control block 151 maintains a wait state until the decode end flag is found received in step S13. When the signal indicative of the end of decoding is found received, the procedure goes to step S14. Namely, the control block 151 controls the reception value memory 152 to output the same value as the value indicated for the first reading in step S12 to the error correction processing block 154.

Having received the reception value and the error position and the error value for this reception value, the error correction processing block 154 executes error correction processing and outputs the error-corrected data to a processing block (not shown) in the post stage. After giving an instruction for the second reading to the reception value memory 152, the control block 151 returns the procedure to step S11 to repeat the above-mentioned processing therefrom.

As described above, the same data is read twice for error correction, thereby reducing memory in storage size and quantity.

It should be noted that the decoding apparatus 150 is configured such that a reception value from the reception value memory 152 is supplied to the BCH decode processing block 153 and the error correction processing block 154 at the same time. In this configuration, a reception value is also supplied to the error correction processing block 154 in the first reading; if the information such as an error position and an error value is not supplied from the BCH decode processing block 153, no error correction processing is executed. Also, to the BCH decode processing block 153, a reception value is supplied in the second reading, but the BCH decode processing block 153 does not execute decode processing on the data supplied in the second reading.

It is also practicable to change to configuration of the decoding apparatus 150 to one in which a switch for switching the supply destination of a reception value outputted from the reception value memory 152 is arranged. Another configuration may also be arranged in which, when switching is executed, a reception value from the reception value memory 152 is supplied to the BCH decode processing block 153 in the first reading and a reception value from the reception value memory 152 is supplied to the error correction processing block 154 in the second reading. In these configurations, the control block 151 gives an instruction to the reception value memory 152 for reading and an instruction to the switch for switching.

### [Second embodiment]

The decoding apparatus 150 is applicable as a decoding apparatus that executes BCH decoding employed by the DTMB scheme, one of the terrestrial digital broadcasting standards, for example. In the case of the DTMB scheme, two information lengths of BCH code configures one TS (Transport Stream) packet. Taking this into consideration, the following describes the case in which processing is executed by one TS packet as the second embodiment.

A reception value for two BCH code lengths, namely, a reception value for one TS packet, is read from the reception value memory 152 in the first reading and an error position and an error value thereof are held in advance. A reception value for two BCH code lengths is read in the second reading. Error correction processing is executed on each BCH code by use of the error position and the error value held in advance. Consequently, the error-corrected data can be passed to processing of the post stage on a TS packet basis.

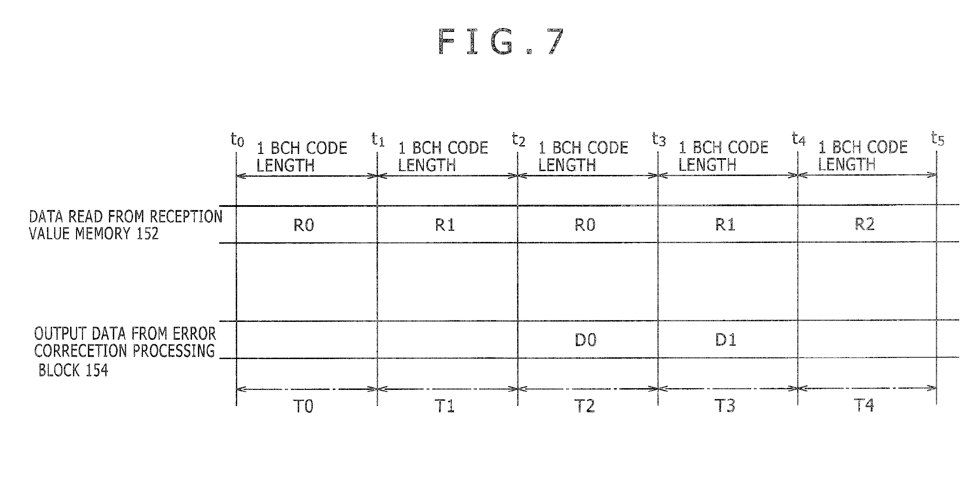

Even if the above-mentioned processing is executed, the decoding apparatus may be configured in substantially the same manner as the decoding apparatus 150 shown in FIG. 4. This can be executed by modifying the processing by the control block 151. The following describes a processing flow of the second embodiment with reference to FIG. 7.

Assume that data R0 be data that is read from the reception value memory 152 in duration T0 from time t0 to time t1 and be a reception value vector for one BCH code length. When data R0 is read from the reception value memory 152 from time t0, this data R0 is supplied to the BCH decode processing block 153. The BCH decode processing block 153 starts the decoding of the supplied data R0 from time t0.

At time t1, the reading of data R0 from the reception value memory 152 is completed and the decoding of data R0 by the BCH decode processing block 153 is completed. The BCH decode processing block 153 holds an error position and an error quantity for data R0. On the other hand, at time t1, data R1 is read from the reception value memory 152. This data R1 is then supplied to the BCH decode processing block 153. The BCH decode processing block 153 starts the decoding of the supplied data R1. At time t2, the reading of data R1 from the reception value memory 152 is complected and the decoding of data R2 by the BCH decode processing block 153 is completed. The BCH decode processing block 153 holds an error position and an error quantity for data R1.

In the first reading, data R0 and data R1 are read as described above. To be more specific, a reception value for two BCH code lengths included in one TS packet is read from the reception value memory 152 to be decoded. The control block 151 may give an instruction to the reception value memory 152 for reading a reception value for one BCH code length or an instruction for reading a reception value for two BCH code lengths.

The second reading starts at time t2 shown in FIG. 7. To be more specific, at time t2, data R0 is read from the reception value memory 152 to be supplied to the error correction processing block 154. In duration T2 from time t2 to time t3, the error correction processing block 154 executes error correction processing on data R0 by use of the error position and the error value of data R0 held in the BCH decode processing block 153. Error-corrected data R0 is outputted to a processing block in the post stage as data D0.

Likewise, at time t3, the second reading of data R1 starts. At time t3, data R1 is read from the reception value memory 152 to be supplied to the error correction processing block 154. In duration T3 from time t3 to time t4, the error correction processing block 154 executes error correction processing on data R1 by use of the error position and the error value of data R1 held in the BCH decode processing block 153. Error-corrected data R1 is outputted to the processing block in the post stage as data D1.

In the second reading, data R0 and data R1 are read as described above. To be more specific, a reception value for two BCH code lengths included in one TS packet is read from the reception value memory 152 to be error-corrected. The control block 151 may give an instruction to the reception value memory 152 for reading a reception value for one BCH code length or an instruction for reading a reception value for two BCH code lengths.

The execution of decoding and error correction as described above allows the continuous outputting of data D0 and data D1. Namely, a result of BCH decoding for two BCH code lengths included in one TS packet is supplied to the processing in the post stage. Consequently, the processing in one TS packet can be executed, thereby providing effects that data can be handled with ease in the processing block in the post stage, such as the simplification of processing.

As described above, if the processing is executed in one TS packet, the processing by the decoding apparatus 150 is executed on the basis of the flowchart shown in FIG. 6. Namely, the processing can be executed in substantially the same flow as that of the first embodiment. The following describes the processing to be executed by the decoding apparatus 150 with reference to FIG. 6 again but only the part of processing that differs from the processing described above.

In step S12, the control block 151 gives an instruction for the first reading to the reception value memory 152. This instruction is for reading a reception value for two BCH code lengths. Consequently, an instruction for reading a reception value for one BCH code length may be given twice or an instruction for reading a reception value for two BCH code length may be given once.

Likewise, in step S14, the control block 151 gives an instruction to the reception value memory 152 for the second reading. This instruction is for reading a reception value for two BCH code lengths. Consequently, an instruction for reading a reception value for one BCH code length may be given twice or an instruction for reading a reception value for two BCH code length may be given once.

As described above, the reading of reception values is executed in step S12 and step S14, so that the decision in step S13 for switching between the first reading and the second reading is the processing in which whether the processing of decoding the reception value for two BCH code lengths has been completed or not is determined.

If the BCH decode processing block 153 is configured such that a decode end flag is outputted when the decoding of a reception value for one BCH code length has been executed, then the control block 151 determines that a signal indicative of the processing of decoding has been received when such a flag has been received twice, upon which the procedure goes to step S14, in which an instruction for the second reading is outputted.

If the BCH decode processing block 153 is configured such that a decode end flag is outputted when the decoding of a reception value for two BCH code lengths has been executed, then the control block 151 determines that a signal indicative of the processing of decoding was received at the reception of this flag, upon which the procedure goes to step S14, in which an instruction for the second reading is outputted.

As described above, the same data are read twice to execute error correction processing, thereby reducing memory in storage size and quantity.

It should be noted that, in the embodiments described above, the description has been made with BCH codes used for an example; it is also practicable to execute the decoding of codes other than BCH codes.

### [Recording medium]

The above-mentioned sequence of processing operations may be executed by software as well as hardware. When the above-mentioned sequence of processing operations is executed by software, the programs constituting the software are installed in a computer which is built in dedicated hardware equipment or installed, from a network or recording medium, into a general-purpose personal computer for example in which various programs may be installed for the execution of various functions.

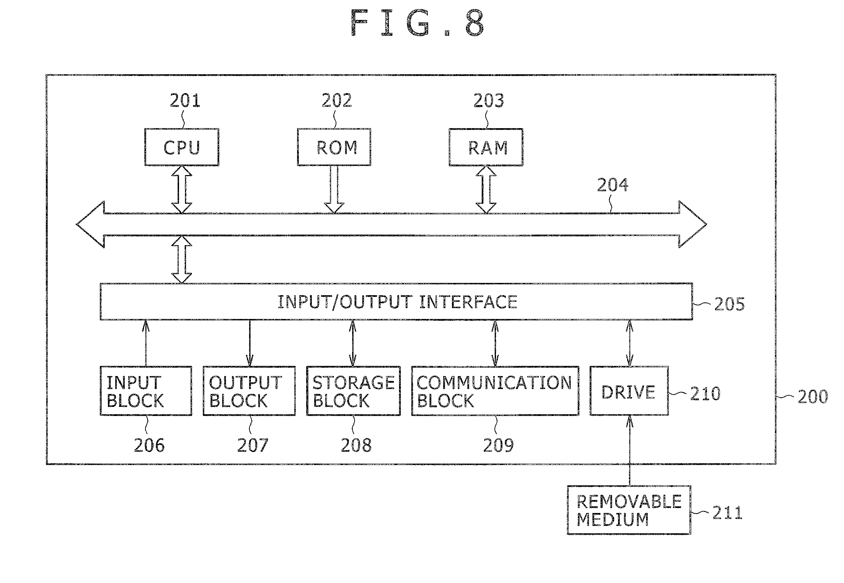

Referring to FIG. 8, there is shown a block diagram illustrating an exemplary hardware configuration of a computer that executes the above-mentioned sequence of processing operations by computer programs. In this computer, a CPU (Central Processing Unit) 201, a ROM (Read Only Memory) 202, and a RAM (Random Access Memory) 203 are interconnected by a bus 204. The bus 204 is connected to an input/output interface 205. The input/output interface 205 is connected to an input block 206, an output block 207, a storage block 208, a communication 209 block, and a drive 210.

The input block 206 is made up of a keyboard, a mouse, and a microphone, for example. The output block 207 is made up of a monitor display and a loudspeaker, for example. The storage block 208 is made up of a hard disk drive or a nonvolatile memory, for example. The communication block 209 is made up of a network interface for example. The drive 210 drives a removable medium 211, such as a magnetic disk, an optical disk, a magnetooptical disk, or a semiconductor memory.

In the computer configured as described above, the CPU 201 loads programs from the storage block 208 into the RAM 203 via the input/output interface 205 and the bus 204 and executes loaded programs, thereby executing the above-mentioned sequence of processing.

Programs to be executed by the computer (the CPU 201) can be provided as recorded to the removable medium 211 that is a package medium, for example. In addition, programs can be provided through wired or wireless transmission medium, such as local area networks, the Internet, and digital satellite broadcasting, for example.

In the above-mentioned computer, programs can be installed from the removable medium 211 loaded on the drive 210 into the storage block 208 via the input/output interface 205. In addition, programs can be received at the communication block 209 via wired or wireless transmission medium and installed in the storage block 208. Alternatively, programs can be installed in the ROM 202 or the storage block 208 in advance.

It should be noted that the programs to be executed by the computer may be executed in a time-dependent manner in the sequences described herein or in parallel or on an on-demand basis.

It should also be noted that term "system" as used herein denotes a logical set of a plurality of component units and these component units are not necessary accommodated in a same housing.

While embodiments of the present invention have been described using specific terms, such description is for illustrative purpose only, and it is to be understood that changes and variations may be made without departing from the spirit or scope of the following claims.

The present disclosure contains subject matter related to that disclosed in Japanese Priority Patent Application JP 2010-240243 filed in the Japan Patent Office on October 27, 2010, the entire content of which is hereby incorporated by reference.

## Claims

1. A decoding apparatus (150) comprising:
a storage section (152) configured to store a reception value;
a detection section (153) configured to detect an error in said reception value;
an error correction section (154) configured to correct an error detected by said detection section with respect to said reception value; and
a control section (151) configured to control reading of said reception value from said storage section;
wherein said control section controls first reading such that said reception value is read into said detection section and, after detection of an error by said detection section, second reading such that substantially the same reception value as that in said first reading is read into said error correction section.

2. The decoding apparatus according to claim 1, wherein said detector executes Bose-Chaudhuri-Hocquenghem decoding.

3. The decoding apparatus according to claim 1, wherein said controller controls reading in unit of a reception value included in one packet.

4. The decoding apparatus according to claim 1, wherein said reception value is data after Low-Density Parity-Check decoding.

5. A decoding method comprising the steps of:
storing a reception value;
detecting an error in said reception value;
correcting an error detected by said detection means with respect to said reception value; and
controlling reading of said reception value from said storage means;
wherein first reading is controlled in said controlling step such that said reception value is read into said detecting step and, after detection of an error by said detection means, second reading is controlled in said control step such that substantially the same reception value as that in said first reading is read into said error correction step.

6. A program for causing a computer to execute the steps of:
storing a reception value;
detecting an error in said reception value;
correcting an error detected by said detection means with respect to said reception value; and
controlling reading of said reception value from said storage means;
wherein first reading is controlled in said controlling step such that said reception value is read into said detecting step and, after detection of an error by said detection means, second reading is controlled in said control step such that substantially the same reception value as that in said first reading is read into said error correction step.
